# EUROPEAN PATENT APPLICATION

(11) **EP 4 650 088 A1**
(43) Date of publication of application: **19.11.2025**
(21) Application number: 24175555.2
(22) Date of filing: 13.05.2024
(51) Int. Cl.: B23K 1/00, B23K 1/008, B23K 3/08, H05K 3/34, B23K 3/047

(54) **REFLOW SOLDERING METHOD AND ELECTRONIC CIRCUIT BOARD ASSEMBLY SYSTEM**

(71) Applicant: Illinois Tool Works Inc., Glenview IL 60025 (US)
(72) Inventor: DIEPSTRATEN, Gerjan, Glenview, 60025 (US)
(74) Representative: HGF

(57) **Abstract**

According to an aspect of the invention there is provided a reflow soldering method for manufacturing an electronic circuit board including a first component and a second component, wherein the first component has a first thermal mass, the second component has a second thermal mass and wherein the second thermal mass is different to the first thermal mass. The reflow soldering method includes: applying a solder paste to a substrate to be soldered; applying the first component to the substrate; applying the second component to the substrate; providing a heating control means proximal to one or both of the first component and the second component; forming a first solder joint between the first component and the substrate by heating the first component and the substrate; and forming a second solder joint between the second component and the substrate using the heater.

## Description

### BACKGROUND

The present invention relates to a reflow soldering method. More particularly, but not exclusively, the present invention relates to a reflow soldering method for manufacturing an electronic circuit board. The present invention also relates to an electronic circuit board assembly system.

During manufacture of printed circuit boards, electronic elements are mounted on the circuit boards generally by means of a process known as "reflow soldering". In a typical reflow soldering process, solder paste (e.g. tin paste) is deposited onto selected areas of a circuit board, and a wire of one or more electronic elements is inserted into the deposited solder paste. The circuit board then passes through a reflow oven in which the soldering paste refluxes (i.e. is heated to a melting or reflux temperature) in a heating area and then cools in a cooling area to form solder joints electrically and mechanically connecting the wires of the electronic components to the circuit board. As used herein, the term "circuit board" comprises a substrate assembly of any type of electronic element, such as comprises a wafer substrate.

There is an increasing number of applications for which a mix of very small (low thermal mass) components and much larger (high thermal mass) components are included on circuit boards. Electric vehicle and 5G technology applications, for example, require large multi-layer printed circuit boards (PCBs) that include small surface mounted devices (SMDs) together with heavy transformers and capacitors. This mismatch of thermal mass creates challenges for reflow process and specifically for convection ovens.

For very small components, the solder paste deposit is small. The printing process should have sufficient stencil release to make sure there is enough solder paste to guarantee proper wetting and solder fillet. Even though there might be enough paste, there is a potential risk for graping. The small amount of paste may not contain enough activators to provide proper solder wetting. As a result, the solder joint may look like grapes and has reduced strength. The key parameter to avoid this is the flux activation. It is about oxidation of the solder paste spheres which can be avoided by having the right chemistry and providing an oxygen free solder environment. The larger high thermal mass devices required longer heating processes that is in contradiction with the flux activation system.

The second risk for very small devices is overheating. The higher the temperature settings of the oven, the better for the high thermal mass devices. A zone temperature of 280°C will heat up the heavy components better, but it may overheat the small devices. Typically, the components may not exceed 260°C. This limits the zone set point of the ovens to maximum 260-265°C.

The third risk for the small components is that the time above liquidus exceeds 90 seconds. The JEDEC/IPC-020 standard defines the maximum time above liquidus. For reliability the inter metallic layer is the critical part. In vacuum applications, this may become more critical because to avoid splattering of the flux it is important to wait a sufficient time (approximately 30 seconds) before starting to decrease the pressure in the chamber. This extra time results in a thicker inter metallic layer that is less strong and may result in early failure.

The IPC-7530 standard describes the reflow profiling. A solder profile is not only product specific but is also flux and alloy dependent. A lead-free process using a Sn3.0Ag0.5Cu alloy is the most common process in the industry at this moment. During the process there are some critical parameters that should be met:
- The peak temperature should be maintained between 230°C and 245°C.
- The dwell time, or `time above liquidus' (TAL) should be 60-90 seconds.

TAL is critical for the quality of the solder joint and its reliability. A sufficient TAL is required to ensure proper wetting and bonding of the solder joints but not excessively long to avoid potential issues like solder joint defects or component damage due to exposure to high temperatures.

The maximum peak packaging body temperatures for small components (<1.6 mm thickness) are defined in the JEDEC-IPC020 specification to be not more than 260°C. For the components the TAL should be between 60 and 150 seconds. Summarizing the requirements:
- Small components not exceeding 260°C for 150 seconds.
- High thermal mass components not less than 60 seconds above 230°C.

These requirements cannot be achieved using current convection reflow ovens. First the heating length and the number of heating zones within convection reflow ovens influence the profiling. More zones make it easier to profile more accurately; although this results in more complex convection reflow oven design. The heat transfer depends on the design of the blower box, the type of the fan and the fan speed. A higher fan speed will increase the heat transfer; however if the speed is too high components may move.

The solder paste and component requirements thus make soldering circuit boards for these applications challenging, particularly where there is a need to produce large numbers of the circuit boards, i.e. for high volume applications.

### SUMMARY OF THE INVENTION

According to an aspect of the invention there is provided a reflow soldering method for manufacturing an electronic circuit board including a first component and a second component, wherein the first component has a first thermal mass, the second component has a second thermal mass and wherein the second thermal mass is different to the first thermal mass. The reflow soldering method includes: applying a solder paste to a substrate to be soldered; applying the first component to the substrate; applying the second component to the substrate; providing a heating control means proximal to one or both of the first component and the second component; forming a first solder joint between the first component and the substrate by heating the first component and the substrate; and forming a second solder joint between the second component and the substrate using the heater.

The heating control means may be configured to control the transfer of heat to one or both of the first component and the second component.

The heating control means may be configured to reduce the transfer of heat, for example reduce the heating of the or each component. In other words, the heating control means may be configured to restrict the temperature to which the or each component is heated.

Alternatively, the heating control means may be configured to increase the transfer of heat, for example increase the heating of the or each component. In other words, the heating control means may be configured to increase the temperature to which the or each component is heated.

Advantageously, the heating control means enables the heating profile of the or each component to be adjusted according to the thermal mass of the component. In this way, components with lower thermal masses can be protected from over-heating and/or components with higher thermal masses can be heated to the required temperature that the solder joint provides the required electrical and mechanical connection between the component and the substrate.

The first thermal mass of the first component may be less than the second thermal mass of the second component, and the heating control means may be configured to reduce the transfer of heat to the first component.

In this way, the first component, which has the lower thermal mass, is protected against over heating by the heater.

The first thermal mass of the first component may be less than the second thermal mass of the second component, and the heating control means may be configured to increase the transfer of heat to the second component.

In this way, the second component, which has the higher thermal mass, is heated to the temperature required to form the second solder joint.

The heater control means may include a cover or shield. The cover or shield may be positioned between the first component and the heater in order to reduce the transfer of heat from the heater to the first component, thereby protecting the first component from overheating.

The cover may extend over the first component and the second component. The cover may include an opening adjacent to the second component, such that the transfer of heat to the first component is reduced, but the transfer of heat from the heater to the second component is not affected.

Advantageously, the cover enables the heating profile of the or each component to be adjusted according to the thermal mass of the component. The cover protects components with lower thermal masses from over-heating and ensures that components with higher thermal masses are heated to the temperature required for the solder joint to provide the necessary electrical and mechanical connection between the component and the substrate.

The cover may include a thermal insulator material, in other words a material that reduces or prevents the transmission of heat to the first component, for example from the heater to the first component. The thermal insulator material may include a ceramic insulator material, for example a calcium-magnesium silicate.

The cover may include one or more perforations or apertures.

The heater may be a first or primary heater. The heater control means may include a second or secondary heater. The secondary heater may be positioned adjacent to the second component in order to increase the transfer of heat to the second component, thereby ensuring that the second component is heated to the required temperature for the formation of the second solder joint.

The secondary heater may be arranged or positioned to only heat the second component (i.e. the or each component having a higher thermal mass) and not influence the heating profile of the rest of the assembly. To achieve this, the secondary heater may be, for example, provided in or on a carrier (also known as a pallet). The carrier may, for example, include an integrated secondary heater and a power supply.

The secondary heater may include one or more of a radiation heater (for example an infra-red lamp), a thermoelectric heater (for example a Peltier device or a Peltier element), or a conduction heater (for example a Polyimide element or heater, a Silicone heater or heating element, or the like).

In some examples of the invention, the heater control means may include a cover or shield that is configured to reduce the transfer of heat to the first component in addition to a secondary heater that is configured to increase the transfer of heat to the second component.

According to an aspect of the invention there is provided a reflow soldering method for manufacturing an electronic circuit board including a first component and a second component, wherein the first component has a first thermal mass, the second component has a second thermal mass and wherein the second thermal mass is greater than the first thermal mass, the reflow soldering method including: applying a solder paste to a substrate to be soldered; applying the first component to the substrate; applying the second component to the substrate; forming a first solder joint between the first component and the substrate by heating the first component and the substrate using a primary heater; and forming a second solder joint between the second component and the substrate by heating the second component and the substrate using the primary heater and a secondary heater.

Heating the second component with the primary heater and the secondary heater enables the second component, which has the higher thermal mass, to be heated to the temperature required to form the second solder joint.

In some examples of the invention, the secondary heater may heat the second component and the substrate by one of conduction heating, radiation heating or thermoelectric heating.

In some examples of the invention, the secondary heater may heat the second component and the substrate by any combination of conduction heating, radiation heating or thermoelectric heating.

The electronic circuit board may include a plurality of second components. Each second component of the plurality of second components may be heated by the same secondary heater, or by different secondary heaters. The or each secondary heater may heat one, some or all of the second components by conduction heating, radiation heating or thermoelectric heating.

In examples of the invention, the primary heater may be a reflow convection oven. The method may include: conveying the substrate into the reflow convection oven; and heating the first component, the second component and the substrate in the reflow convection oven.

The method may include: placing the substrate on a carrier; and conveying the carrier into the reflow convection oven.

In examples of the invention, the secondary heater may be provided on the carrier.

Alternatively, the secondary heater may provided in, for example, within a or the reflow convection oven.

In examples of the invention in which the method uses more than one secondary heater, the secondary heaters may be provided on the carrier and/or within the reflow convection oven. In other words, one, some or all of the secondary heaters may be provided on the carrier and one, some or all of the secondary heaters may be provided within the reflow convection oven.

The secondary heater may be configured to receive power from a pin conveyor of a reflow soldering system. Alternatively, the secondary heater may be configured to receive power from an external power supply of a or the reflow convection oven.

The method may include using a cover or shield to reduce the transfer of heat from the primary heater to the first component.

The cover may include a thermal insulator material, in other words a material that reduces or prevents the transmission of heat to the first component, for example from the heater to the first component. The thermal insulator material may include a ceramic insulator material, for example a calcium-magnesium silicate.

The cover may include one or more perforations or apertures.

The method may include applying the cover to a surface of the substrate. The method may, for example include applying the cover to an upper or a lower surface of the substrate.

According to an aspect of the invention there is provided a reflow soldering method for manufacturing an electronic circuit board including a first component and a second component, wherein the first component has a first thermal mass and the second component has a second thermal mass and wherein the second thermal mass is greater than the first thermal mass, the reflow soldering method including: applying a solder paste to a substrate to be soldered; applying a first component to the substrate; applying a second component to the substrate; applying a cover that is configured to reduce the transfer of heat to the first component; forming a first solder joint between the first component and the substrate by heating the first component and the substrate using a heater; and forming a second solder joint between the second component and the substrate by heating the second component and the substrate using the heater.

The invention may include applying the cover between the first component and the heater in order to reduce the transfer of heat from the heater to the first component.

The cover may include a thermal insulator material, in other words a material that reduces or prevents the transmission of heat to the first component, for example from the heater to the first component. The thermal insulator material may include a ceramic insulator material, for example a calcium-magnesium silicate.

The cover may include one or more perforations or apertures.

The method may include applying the cover to a first, upper, surface, of the substrate.

The method may include applying the cover to a second, lower, surface of the substrate.

The cover may be a first cover. The method may include applying the first cover to one of the first, upper, surface and the second, lower, surface of the substrate and applying a second cover to the other of the first, upper, surface and the second, lower surface.

The method may include applying the cover to a carrier or pallet on which the substrate is conveyed.

The electronic circuit board may include a plurality of first components. Each first component of the plurality of first components may be covered or shielded by the same cover, or by different covers.

According to an aspect of the invention there is provided an electronic circuit board assembly system including: an electronic circuit board assembly including: a substrate; a first component having a first thermal mass; and a second component having a second thermal mass, wherein the second thermal mass is greater than the first thermal mass; wherein the first component and the second component are adhered to the substrate by a solder paste; and wherein the electronic circuit board assembly system includes a reflow convection oven that is configured to heat the first component, the second component and the substrate; and, wherein the electronic circuit board assembly system includes a secondary heater that is configured to heat the second component.

The secondary heater may be one of a conduction heater, a radiation heater and a thermoelectric heater.

The secondary heater may be configured to receive power from a pin conveyor of a reflow soldering system. The secondary heater may be configured to receive power from an external power supply of the reflow convection oven.

In examples of the invention, the electronic circuit board assembly system may include: a cover. The cover may be configured to reduce the transfer of heat from the reflow convection oven and/or the secondary heater to the first component.

According to an aspect of the invention there is provided an electronic circuit board assembly system including an electronic circuit board assembly including: a substrate; a first component having a first thermal mass; and a second component having a second thermal mass, wherein the second thermal mass is greater than the first thermal mass; wherein the first component and the second component are adhered to the substrate by a solder paste; and wherein the electronic circuit board assembly system includes a reflow convection oven that is configured to heat the first component, the second component and the substrate; and, wherein the electronic circuit board assembly includes a cover that is configured to reduce the transfer of heat from the reflow convection oven to the first component.

In examples of the invention, the cover may extend from a surface of the carrier.

Alternatively, the cover extends from a surface of the electronic circuit board assembly, for example a surface of the substrate of the electronic circuit board assembly.

In examples of the invention, the cover may extend over the first component.

Alternatively, the cover may extend over the first component and the second component. The cover may include an opening adjacent the second component.

The electronic circuit board assembly may include a plurality of second components. The cover may include a plurality of openings. Each opening of the plurality of openings may be aligned with one of the plurality of second components.

### BRIEF DESCRIPTION OF THE DRAWINGS

Embodiments of the invention are now described, by way of example only, hereinafter with reference to the accompanying drawings.
FIG. 1 illustrates an electronic circuit board assembly system;
FIG. 2 illustrates an electronic circuit board assembly system according to an embodiment of the invention;
FIG. 3 illustrates an electronic circuit board assembly system according to another embodiment of the invention;
FIG. 4 illustrates an electronic circuit board assembly system according to a further embodiment of the invention;
FIG. 5 illustrates an electronic circuit board assembly system according to an embodiment of the invention;
FIG. 6 illustrates an electronic circuit board assembly system according to an embodiment of the invention;
FIG. 7 illustrates a reflow soldering method according to an embodiment of the invention; and
FIG. 8 illustrates a reflow soldering method according to an embodiment of the invention.

### DETAILED DESCRIPTION

Certain terminology is used in the following description for convenience only and is not limiting. The words 'right', 'left', 'lower', 'upper', 'front', 'rear', 'upward', 'down' and 'downward' designate directions in the drawings to which reference is made and are with respect to the described component when assembled and mounted. The words 'inner', `inwardly', `outer' and 'outwardly' refer to directions toward and away from, respectively, a designated centreline or a geometric centre of an element being described (e.g. central axis), the particular meaning being readily apparent from the context of the description.

Further, as used herein, the terms 'connected', 'attached', 'coupled' and 'mounted' are intended to include direct connections between two members without any other members interposed therebetween, as well as, indirect connections between members in which one or more other members are interposed therebetween. The terminology includes the words specifically mentioned above, derivatives thereof, and words of similar import.

Further, unless otherwise specified, the use of ordinal adjectives, such as, "first", "second" and "third" etc. merely indicate that different instances of like objects are being referred to and are not intended to imply that the objects so described must be in a given sequence, either temporally, spatially, in ranking or in any other manner.

Like reference numerals are used to depict like features throughout.

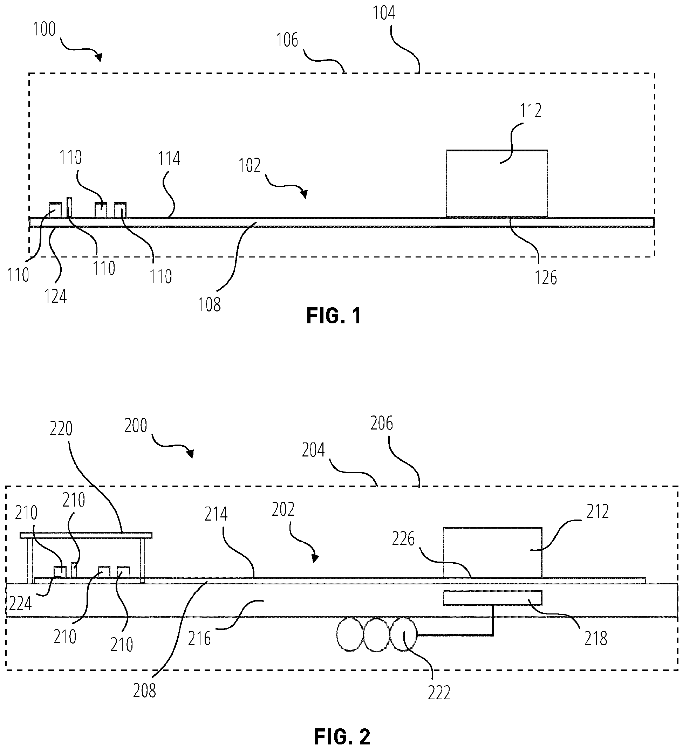

With reference to FIG. 1, there is shown an electronic circuit board assembly system 100 which has an electronic circuit board assembly 102 and a heater 104, which in this embodiment is a reflow convection oven 106.

The electronic circuit board assembly 102 includes a substrate 108, four first components 110 and a second component 112.

Each of the first components 110 is smaller than the second component 112.

Each of the first components 110 and the second component 112 are adhered to the substrate 108 by a solder paste 114.

The reflow convection oven 106 is used to heat the first components 110, the second component 112 and the substrate 108. In this way a first solder joint 124 is formed by the solder paste 114 between the substrate 108 and each of the first components 110 and a second solder joint 126 is formed by the solder paste 114 between the substrate 108 and the second component 112.

Each of the first components 110 is smaller than the second component 112, and so the first components 110 each have a first thermal mass that is less than the second thermal mass of the second component 112.

As a result, when the electronic circuit board assembly 102 is heated in the reflow convection oven 106, each of the first components 110 heats up more quickly than the second component 112. This can result in the first component 110 being over-heated (and damaged) and/or the second component 112 not being heated enough (and therefore the second solder joint 126 not providing an adequate mechanical and/or electrical connection between the second component 112 and the substrate 108 of the electronic circuit board assembly 102).

Referring now to FIG. 2, there is shown an electronic circuit board assembly system 200 according to an embodiment of the present invention. The electronic circuit board assembly system 200 has an electronic circuit board assembly 202 and a heater 204, which in this example is a first, or primary, heater, in the form of a reflow convection oven 206.

The electronic circuit board assembly 202 includes a substrate 208, four first components 210 and a second component 212

Each of the first components 210 is smaller than the second component 212.

Each of the first components 210 and the second component 212 is adhered to the substrate 208 by a solder paste 214.

The electronic circuit board assembly system 200 also includes a carrier 216, a secondary heater 218 and a cover 220.

The secondary heater 218 is provided on the carrier 216 and is positioned below the substrate 208 proximal to the second component 212.

The secondary heater 218 is, in this example, a conduction heater and is connected to an external power supply 222.

The cover 220 extends upwardly from the substrate 208. The cover 220 also extends over each of the four first components 210.

In use, the reflow convection oven 206 is used to heat each of the first components 210, the second component 212 and the substrate 208.

The cover 220 is positioned around the first components 210, the reflow convection oven 206 and the substrate 208, thereby reducing the transfer of heat to the first components 210 and ensuring that the temperature is adequate to form first solder joints 224 that provide the required mechanical and electrical connections between the first components 210 and the substrate 208, as well as preventing over-heating of any of the first components 210.

The secondary heater 218 is positioned adjacent to the second component 212 such that the transfer of heat to the second component 212 is increased. In this way, the temperature of the second component 212 and the substrate 208 that is proximal to the second component 212 is heated to a temperature that is adequate to ensure that the second solder joint 226 provides a suitable mechanical and electrical connection between the second component 212 and the substrate 208.

The provision of a cover 220 and/or a secondary heater 218 advantageously enables the heat transfer properties of the electronic circuit board assembly system 200 to be tailored to accommodate the manufacture of electronic circuit board assemblies 202 that include components of different sizes and thermal masses.

In the embodiment shown in FIG. 2, the cover 220 is positioned above the electronic circuit board assembly 202 and the carrier 216 and the secondary heater 218 is positioned on the carrier 216 below the electronic circuit board assembly 202.

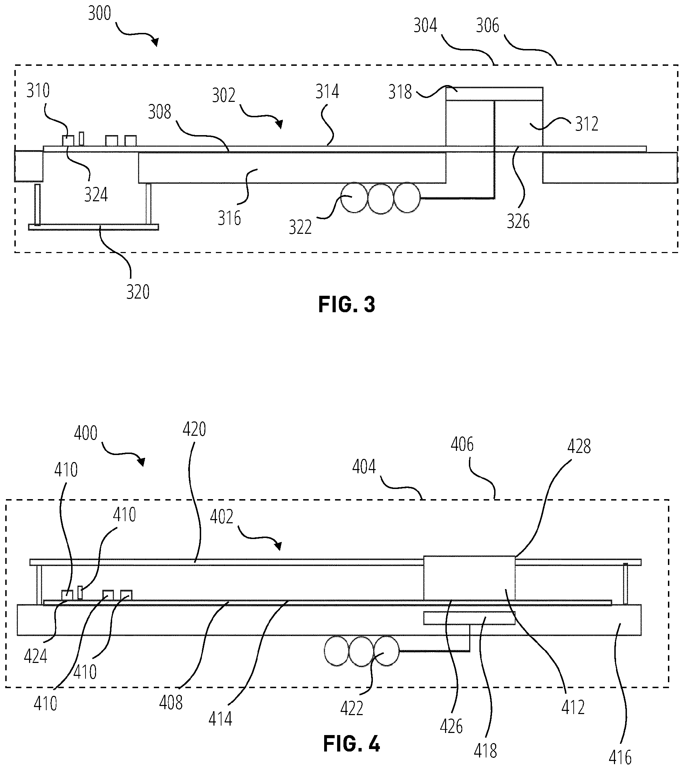

An electronic circuit board assembly system 300 according to an alternative embodiment of the invention will now be described with reference to FIG. 3.

The electronic circuit board assembly system 300 has an electronic circuit board assembly 302 and a heater 304, which in this example is a first, or primary, heater, in the form of a reflow convection oven 306.

The electronic circuit board assembly 302 includes a substrate 308, four first components 310 and a second component 312

Each of the first components 310 is smaller than the second component 312.

Each of the first components 310 and the second component 312 is adhered to the substrate 308 by a solder paste 314.

The electronic circuit board assembly system 300 also includes a carrier 316, a secondary heater 318 and a cover 320.

The secondary heater 318 is provided on the carrier 316 and is positioned below the substrate 308 proximal to the second component 312.

The secondary heater 318 is, in this example, a conduction heater and is connected to an external power supply 322.

The cover 320 extends downwardly from the carrier 316 and the substrate 308. The cover 320 also extends over each of the four first components 310.

In use, the reflow convection oven 306 is used to heat each of the first components 310, the second component 312 and the substrate 308.

The cover 320 is positioned around the first components 310, the reflow convection oven 206 and the substrate 308, thereby reducing the transfer of heat to the first components 310 and ensuring that the temperature is adequate to form first solder joints 324 that provide the required mechanical and electrical connections between the first components 310 and the substrate 308, as well as preventing over-heating of any of the first components 310.

The secondary heater 318 is positioned adjacent to the second component 312 above the second component 312 and the carrier 316 such that the transfer of heat to the second component 312 is increased. In this way, the temperature of the second component 312 is heated to a temperature that is adequate to ensure that the second solder joint 326 provides a suitable mechanical and electrical connection between the second component 312 and the substrate 308.

The provision of a cover 320 and/or a secondary heater 318 advantageously enables the heat transfer properties of the electronic circuit board assembly system 300 to be tailored to accommodate the manufacture of electronic circuit board assemblies electronic circuit board assembly 302 that include components of different sizes and thermal masses.

Another embodiment of the invention will now be described with particular reference to FIG. 4.

The electronic circuit board assembly system 400 has an electronic circuit board assembly 402 and a heater 404, which in this example is a first, or primary, heater, in the form of a reflow convection oven 406.

The electronic circuit board assembly 402 includes a substrate 408, four first components first components 410 and a second component 412.

Each of the first components 410 is smaller than the second component 412.

Each of the first components 410 and the second component 412 is adhered to the substrate 408 by a solder paste 414.

The electronic circuit board assembly system 400 also includes a carrier 416, a secondary heater 418 and a cover 420.

The secondary heater 418 is provided on the carrier 416 and is positioned below the substrate 408 proximal to the second component 412.

The secondary heater 418 is, in this example, a conduction heater and is connected to an external power supply 422.

The cover 420 extends upwardly from the substrate 408. The cover 420 also extends over each of the four first components 410 and the second component 412. The cover 420 includes an opening 428, which is adjacent to the second component 412.

In use, the reflow convection oven 406 is used to heat each of the first components 410, the second component 412 and the substrate 408.

The cover 420 is positioned around the first components 410, the reflow convection oven 406 and the substrate 408, thereby reducing the transfer of heat to the first components 410 and ensuring that the temperature is adequate to form first solder joints 424 that provide the required mechanical and electrical connections between the first components 410 and the substrate 408, as well as preventing over-heating of any of the first components 410.

The secondary heater 418 is positioned adjacent to the second component 412 such that the transfer of heat to the second component 412 is increased. In this way, the temperature of the second component 412 and the substrate 408 that is proximal to the second component 412 is heated to a temperature that is adequate to ensure that the second solder joint 426 provides a suitable mechanical and electrical connection between the second component 412 and the substrate 408.

The provision of a cover 420 and/or a secondary heater 418 advantageously enables the heat transfer properties of the electronic circuit board assembly system 400 to be tailored to accommodate the manufacture of electronic circuit board assemblies electronic circuit board assembly 402 that include components of different sizes and thermal masses.

The embodiments of the invention that are shown in FIG. 2, FIG. 3 and FIG. 4 each show electronic circuit board assembly systems 200, 300, 400 that each include a cover 220, 320, 420 and a secondary heater 218, 318, 418.

It will be appreciated that the transfer of heat to the first component and/or the second component may be tailored according to the relative thermal masses of the components using either a cover or a secondary heater.

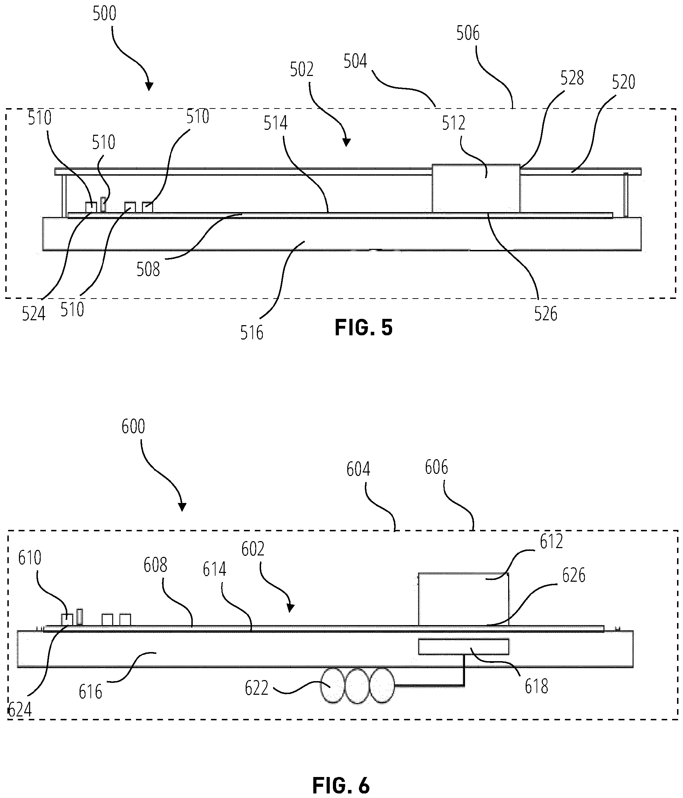

Examples of such embodiments will now be described with reference to FIG. 5 and FIG. 6.

Referring now to FIG. 5 there is shown an electronic circuit board assembly system 500 that has an electronic circuit board assembly 502 and a heater 504, which in this example is in the form of a reflow convection oven 506.

The electronic circuit board assembly 502 includes a substrate 508, four first components first components 510 and a second component 512.

Each of the first components 510 is smaller than the second component 512.

Each of the first components 510 and the second component 512 is adhered to the substrate 508 by a solder paste 514.

The electronic circuit board assembly system 500 also includes a carrier 516 and a cover 520.

The cover 520 extends upwardly from the carrier 516. The cover 520 also extends over each of the four first components 510 and the second component 512. The cover 520 includes an opening 528, which is adjacent to the second component 512.

In use, the reflow convection oven 506 is used to heat each of the first components 510, the second component 512 and the substrate 508.

The cover 520 is positioned around the first components 510, the reflow convection oven 506 and the substrate 508, thereby reducing the transfer of heat to the first components first component 510 and ensuring that the temperature is adequate to form first solder joints 524 that provide the required mechanical and electrical connections between the first components 510 and the substrate 508, as well as preventing over-heating of any of the first components 510.

The opening 528 is positioned adjacent to the second component 512 such that the transfer of heat to the second component 512 from the reflow convection oven 506 is not affected and, in particular, is not reduced. In this way, the temperature of the second component 512 and the substrate 508 that is proximal to the second component 512 is heated to a temperature that is adequate to ensure that the second solder joint 526 provides a suitable mechanical and electrical connection between the second component 512 and the substrate 508.

The provision of a cover 520 advantageously enables the heat transfer properties of the electronic circuit board assembly system 500 to be tailored to accommodate the manufacture of electronic circuit board assemblies 502 that include components of different sizes and thermal masses.

The electronic circuit board assembly system 600 has an electronic circuit board assembly 602 and a heater 604, which in this example is a first, or primary, heater, in the form of a reflow convection oven 606.

The electronic circuit board assembly 602 includes a substrate 608, four first components 610 and a second component 612.

Each of the first components 610 is smaller than the second component 612.

Each of the first components 610 and the second component 612 is adhered to the substrate 608 by a solder paste 614.

The electronic circuit board assembly system 600 also includes a carrier 616 and a secondary heater 618.

The secondary heater 618 is provided on the carrier 616 and is positioned below the substrate 608 proximal to the second component 612.

The secondary heater 618 is, in this example, a conduction heater and is connected to an external power supply 622.

In use, the reflow convection oven 606 is used to heat each of the first components 610, the second component 612 and the substrate 608.

The secondary heater 618 is positioned adjacent to the second component 612 such that the transfer of heat to the second component 612 is increased. In this way, the temperature of the second component 612 and the substrate 608 that is proximal to the second component 612 is heated to a temperature that is adequate to ensure that the second solder joint 62 provides a suitable mechanical and electrical connection between the second component 412 and the substrate 408.

The provision of a secondary heater 418 advantageously enables the heat transfer properties of the electronic circuit board assembly system 400 to be tailored to accommodate the manufacture of electronic circuit board assemblies electronic circuit board assembly 402 that include components of different sizes and thermal masses.

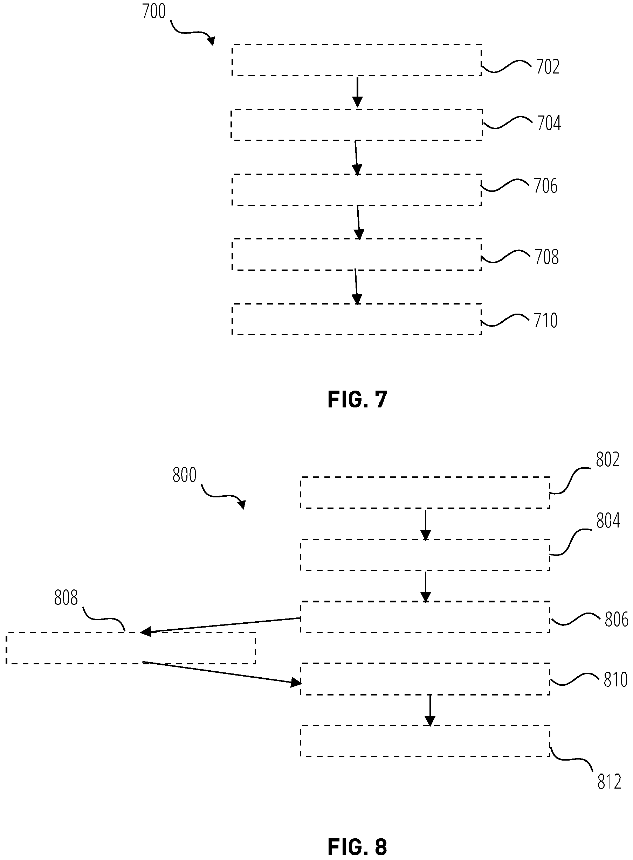

A reflow soldering method 700 for manufacturing an electronic circuit board assembly 202, 302, 402, 602 comprising a first component 210, 310, 410, 610 and a second component 212, 312, 412, 612, wherein the first component has a first thermal mass and the second component has a second thermal mass and wherein the second thermal mass is greater than the first thermal mass according to an embodiment of the invention will now be described with reference to FIG. 7.

The reflow soldering method 700 includes, in step 702, applying a solder paste 214, 314, 414, 614 to a substrate 208, 308, 408, 608.

In step 704, a first component 210, 310, 410, 610 is positioned on the solder paste 214, 314, 414, 614 on a first portion of the substrate 208, 308, 408, 608.

A second component 212, 312, 412, 612 is similarly positioned on the solder paste 214, 314, 414, 614 on a second portion of the substrate 208, 308, 408, 608 in step 706.

A primary heater 204, 304, 404, 604, in the form of a reflow convection oven 206, 306, 406, reflow convection oven 606 is used to form a first solder joint 224, 324, 424, 624 between the first component 210, 310, 410, 610 and the first portion of the substrate 208, 308, 408, 608 in step 708.

Similarly, in step 710, a second solder joint 226, 326, 426, 626 is formed between the second component 212, 312, 412, 612 and the second portion of the substrate 208, 308, 408, 608 using the reflow convection oven 206, 306, 406, 606. In this step, a secondary heater 218, 318, 418, 618 is used to supplement the heating of the second component 212, 312, 412, 612 to ensure that the larger second component 212, 312, 412, 612 is heated sufficiently to enable the formation of a second solder joint 226, 326, 426, 626 that provides the required mechanical and electrical connection between the second component 212, 312, 412, 612 and the substrate 208, 308, 408, 608.

The use of a secondary heater 218, 318, 418, 618 to supplement the heating of the larger, second component 212, 312, 412, 612 means that the reflow convection oven 206, 306, 406, 606 heating can be provided at a temperature or heat transfer rate that does not cause damage, for example by over-heating to the smaller, first component 210, 310, 410, 610.

A reflow soldering method 800 for manufacturing an electronic circuit board assembly 202, 302, 402, 502 comprising a first component 210, 310, 410, 510 and a second component 212, 312, 412, 512, wherein the first component has a first thermal mass and the second component has a second thermal mass and wherein the second thermal mass is greater than the first thermal mass according to an embodiment of the invention will now be described with reference to FIG. 8.

The reflow soldering method 800 includes, in step 802, applying a solder paste 214, 314, 414, 514 to a substrate 208, 308, 408, 508.

In step 804, a first component 210, 310, 410, 510 is positioned on the solder paste 214, 314, 414, 514 on a first portion of the substrate 208, 308, 408, 508.

A second component 212, 312, 412, 512 is similarly positioned on the solder paste 214, 314, 414, 514 on a second portion of the substrate 208, 308, 408, 508 in step 806.

In step 808, a cover 220, 320, 420, 520 that is configured to reduce the transfer of heat to the first component 210, 310, 410, 510 is applied to the electronic circuit board assembly 202, 302, 402, 502.

A heater 204, 304, 404, 504, in the form of a reflow convection oven 206, 306, 406, 506 is used to form a first solder joint 224, 324, 424, 524 between the first component 210, 310, 410, 510 and the first portion of the substrate 208, 308, 408, 508 in step 810.

Similarly, in step 812, a second solder joint 226, 326, 426, 526 is formed between the second component 212, 312, 412, 512 and the second portion of the substrate 208, 308, 408, 508 using the reflow convection oven 206, 306, 406, 506.

The use of a cover 220, 320, 420, 520 to reduce the transfer of heat to the first component 210, 310, 410, 510 enables the reflow convection oven 206, 306, 406, 506 to be used at a temperature that is suitable for heating of the larger, second component 212, 312, 412, 512 without causing damage, for example by over-heating to the smaller, first component 210, 310, 410, 510.

It will be appreciated by persons skilled in the art that the above detailed examples have been described by way of example only and not in any limitative sense, and that various alterations and modifications are possible without departing from the scope of the invention as defined by the appended claims. Various modifications to the detailed examples described above are possible.

Through the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments. The invention extends to any novel one, or any novel combination, of the features disclosed in this specification (including any accompanying claims, abstract or drawings), or to any novel one, or any novel combination, of the steps of any method or process so disclosed.

Certain embodiments of the invention are described in the following clauses:
1. A reflow soldering method for manufacturing an electronic circuit board comprising a first component and a second component, wherein the first component has a first thermal mass, the second component has a second thermal mass and wherein the second thermal mass is greater than the first thermal mass, the soldering method comprising: applying a solder paste to a substrate to be soldered; applying the first component to the substrate; applying the second component to the substrate; forming a first solder joint between the first component and the substrate by heating the first component and the substrate using a primary heater; and forming a second solder joint between the second component and the substrate by heating the second component and the substrate using the primary heater and a secondary heater.
2. The reflow soldering method of clause 1, wherein the secondary heater heats the second component and the substrate by one of conduction heating, radiation heating or thermoelectric heating.
3. The reflow soldering method of clause 1 or 2, wherein the primary heater is a reflow convection oven and the method comprises: conveying the substrate into the reflow convection oven; and heating the first component, the second component and the substrate in the reflow convection oven.
4. The reflow soldering method of clause 3 comprising placing the substrate on a carrier; and conveying the carrier into the reflow convection oven.
5. The reflow soldering method of any one of clauses 1 to 4, wherein the secondary heater is provided on the carrier.
6. The reflow soldering method of any one of clauses 1 to 4, wherein the secondary heater is provided in a or the reflow convection oven.
7. The reflow soldering method of any one of clauses 1 to 6, wherein the secondary heater is configured to receive power from a pin conveyor of a reflow soldering system.
8. The reflow soldering method of any one of clauses 1 to 6, wherein the secondary heater is configured to receive power from an external power supply of a or the reflow convection oven.
9. The reflow soldering method of any one of clauses 1 to 8, comprising: using a cover to reduce the transfer of heat from the primary heater to the first component.
10. A reflow soldering method for manufacturing an electronic circuit board comprising a first component and a second component, wherein the first component has a first thermal mass and the second component has a second thermal mass and wherein the second thermal mass is greater than the first thermal mass, the reflow soldering method comprising: applying a solder paste to a substrate to be soldered; applying a first component to the substrate; applying a second component to the substrate; applying a cover that is configured to reduce the transfer of heat to the first component to the substrate; forming a first solder joint between the first component and the substrate by heating the first component and the substrate using a heater; and forming a second solder joint between the second component and the substrate by heating the second component and the substrate using the heater.
11. The reflow soldering method of clause 9 or 10, comprising applying the cover between the first component and the heater in order to reduce the transfer of heat from the heater to the first component.
12. An electronic circuit board assembly system comprising: an electronic circuit board assembly comprising: a substrate; a first component having a first thermal mass; and a second component having a second thermal mass, wherein the second thermal mass is greater than the first thermal mass; wherein the first component and the second component are adhered to the substrate by a solder paste; and wherein the electronic circuit board assembly system comprises a reflow convection oven that is configured to heat the first component, the second component and the substrate; and, wherein the electronic circuit board assembly system comprises a secondary heater that is configured to heat the second component.
13. The electronic circuit board assembly system of clause 12, wherein the secondary heater is one of a conduction heater, a radiation heater and a thermoelectric heater.
14. The electronic circuit board assembly system of clause 12 or 13, wherein the secondary heater is configured to receive power from a pin conveyor of a reflow soldering system.
15. The electronic circuit board assembly system of clause 12 or 13, wherein the secondary heater is configured to receive power from an external power supply of the reflow convection oven.
16. The electronic circuit board assembly system of any one of clauses 12 to 15, comprising: a cover; wherein the cover is configured to reduce the transfer of heat from the reflow convection oven and/or the secondary heater to the other of the first component.
17. An electronic circuit board assembly system comprising: an electronic circuit board assembly comprising: a substrate; a first component having a first thermal mass; and a second component having a second thermal mass, wherein the second thermal mass is greater than the first thermal mass; wherein the first component and the second component are adhered to the substrate by a solder paste; and wherein the electronic circuit board assembly system comprises a reflow convection oven that is configured to heat the first component, the second component and the substrate; and, wherein the electronic circuit board assembly comprises a cover that is configured to reduce the transfer of heat from the reflow convection oven to the first component.
18. The electronic circuit board assembly system of clause 16 or 17, wherein the cover extends from a surface of the carrier.
19. The electronic circuit board assembly system of clause 16 or 17, wherein the cover extends from a surface of the electronic circuit board assembly.
20. The electronic circuit board assembly system of clause 19, wherein the cover extends from a surface of the substrate of the electronic circuit board assembly.
21. The electronic circuit board assembly system of any one of clauses 18 to 20, wherein the cover extends over the first component.
22. The electronic circuit board assembly system of any one of clauses 18 to 20, wherein the cover extends over the first component and the second component.
23. The electronic circuit board assembly system of clause 22, wherein the cover comprises an opening adjacent the second component.
24. The electronic circuit board assembly system of clause 23, wherein the electronic circuit board assembly comprises a plurality of second components and the cover comprises a plurality of openings; wherein each opening of the plurality of openings is aligned with one second component of the plurality of second components.

### LIST OF FEATURES

- 100, 200, 300, 400, 500, 600: Electronic circuit board assembly system
- 102, 202, 302, 402, 502, 602: Electronic circuit board assembly
- 104, 204, 304, 404, 504, 604: Heater
- 106, 206, 306, 406, 506, 606: Reflow convection oven
- 108, 208, 308, 408, 508, 608: Substrate
- 110, 210, 310, 410, 510, 610: First component
- 112, 212, 312, 412, 512, 612: Second component
- 114, 214, 314, 414, 514, 614: Solder paste
- 216,316,416,516,616: Carrier
- 218, 318, 418, 618: Secondary heater
- 220, 320, 420, 520: Cover
- 222, 322, 422, 622: External power supply
- 124, 224, 324, 424, 524, 624: First solder joint
- 126, 226, 326, 426, 526, 626: Second solder joint
- 428, 528: Opening
- 700: Reflow soldering method
- 702, 704, 706, 708, 710: Reflow soldering method steps
- 800: Reflow soldering method
- 802, 804, 806, 808, 810, 812: Reflow soldering method steps

## Claims

1. A reflow soldering method for manufacturing an electronic circuit board comprising a first component and a second component, wherein the first component has a first thermal mass and the second component has a second thermal mass and wherein the second thermal mass is greater than the first thermal mass, the reflow soldering method comprising:
applying a solder paste to a substrate to be soldered;
applying a first component to the substrate;
applying a second component to the substrate;
applying a cover that is configured to reduce the transfer of heat to the first component to the substrate;
forming a first solder joint between the first component and the substrate by heating the first component and the substrate using a heater; and
forming a second solder joint between the second component and the substrate by heating the second component and the substrate using the heater.

2. The reflow soldering method of claim 1, comprising applying the cover between the first component and the heater in order to reduce the transfer of heat from the heater to the first component.

3. The reflow soldering method of claim 1 or claim 2, wherein the heater is a primary heater, the, and the soldering method comprises:
forming the second solder joint between the second component and the substrate by heating the second component and the substrate using the primary heater and a secondary heater.

4. The reflow soldering method of claim 3, wherein the secondary heater heats the second component and the substrate by one of conduction heating, radiation heating or thermoelectric heating.

5. The reflow soldering method of claim 3 or 4, wherein the primary heater is a reflow convection oven and the method comprises:
conveying the substrate into the reflow convection oven; and
heating the first component, the second component and the substrate in the reflow convection oven; and optionally
placing the substrate on a carrier; and
conveying the carrier into the reflow convection oven.

6. The reflow soldering method of any one of claims 3 to 5, wherein the secondary heater is provided on the carrier, or wherein the secondary heater is provided in a or the reflow convection oven.

7. The reflow soldering method of any one of claims 3 to 6, wherein the secondary heater is configured to receive power from a pin conveyor of a reflow soldering system, or wherein the secondary heater is configured to receive power from an external power supply of a or the reflow convection oven.

8. An electronic circuit board assembly system comprising:
an electronic circuit board assembly comprising:
a substrate;
a first component having a first thermal mass; and
a second component having a second thermal mass, wherein the second thermal mass is greater than the first thermal mass;
wherein the first component and the second component are adhered to the substrate by a solder paste; and
wherein the electronic circuit board assembly system comprises a reflow convection oven that is configured to heat the first component, the second component and the substrate; and,
wherein the electronic circuit board assembly comprises a cover that is configured to reduce the transfer of heat from the reflow convection oven to the first component.

9. The electronic circuit board assembly system of claim 8, wherein the cover extends from a surface of the carrier.

10. The electronic circuit board assembly system of claim 8, wherein the cover extends from a surface of the electronic circuit board assembly, for example wherein the cover extends from a surface of the substrate of the electronic circuit board assembly.

11. The electronic circuit board assembly system of any one of claims 8 to 10, wherein the cover extends over the first component.

12. The electronic circuit board assembly system of any one of claims 8 to 10, wherein the cover extends over the first component and the second component, and wherein the cover comprises an opening adjacent the second component.

13. The electronic circuit board assembly system of claim 12, wherein the electronic circuit board assembly comprises a plurality of second components and the cover comprises a plurality of openings; wherein each opening of the plurality of openings is aligned with one second component of the plurality of second components.

14. The electronic circuit board assembly system comprising:
wherein the electronic circuit board assembly system comprises a secondary heater that is configured to heat the second component.

15. The electronic circuit board assembly system of claim 14, wherein the secondary heater is one of a conduction heater, a radiation heater and a thermoelectric heater.
